# EUROPÄISCHE PATENTSCHRIFT

(11) **EP 2 099 274 B1**
(45) Veröffentlichungstag und Bekanntmachung des Hinweises auf die Patenterteilung: **01.09.2010**
(21) Anmeldenummer: 08152223.7
(22) Anmeldetag: 03.03.2008
(51) Int. Cl.: H05K 7/20

(54) **Gehäuse zur Aufnahme von elektronischen Steckbaugruppen**
Casing to install electric plug-in components
Boîtier destiné à la réception de modules enfichables électroniques

(43) Veröffentlichungstag der Anmeldung: 09.09.2009
(73) Patentinhaber: Schroff GmbH, D-75334 Straubenhardt (DE)
(72) Erfinder: Kempf, Heinz, 75365, Calw-Altburg (DE)
(74) Vertreter: Petirsch, Markus

(56) Entgegenhaltungen:
- EP-A- 1 705 977
- DE-A1- 10 008 019
- DE-A1-102005 056 096
- DE-U1- 8 902 015

## Beschreibung

Die vorliegende Erfindung betrifft ein Gehäuse zur Aufnahme von elektronischen Steckbaugruppen mit einem zur Vorderseite des Gehäuses offenen Einbauraum für die Steckbaugruppen und einem oberhalb des Einbauraums angeordneten Lüfterraum mit einem seitlichen Luftaustritt und einem Axiallüfter.

Gehäuse mit elektronischen Steckbaugruppen werden üblicherweise in Schaltschränken zusammengefasst. Die Bauhöhe des Gehäuses muss im Vergleich zu den eingeschobenen Steckbaugruppen möglichst klein sein, um den zur Verfügung stehenden Raum im Schaltschrank optimal zu nutzen und um die auf die Standfläche des Schaltschrankes bezogenen Kosten zu reduzieren.

Aufgrund der hohen Dichte von elektronischen Steckbaugruppen ergeben sich jedoch Probleme mit der Erwärmung. Die abzuführende Verlustleistung der Steckbaugruppen, die sich durch die erhöhte Packungsdichte und durch hohe Taktfrequenzen der Steckbaugruppe vergrößert, steigt stetig an. Somit werden an die Systeme und insbesondere die Gehäuse zur Aufnahme der Steckbaugruppen erhöhte Anforderungen in Bezug auf die Kühlung gestellt.

Im Bereich der Telekommunikation wird eine besonders starke Kühlung gefordert, da die Normung im Bereich der Telekommunikationsanwendungen Verlustleistungen von über 200 Watt pro Steckbaugruppe zulässt. Das von der PICMG (PCI Industrial Computing Manufacture Group) entwickelte ATCA-Standard-Gehäuse (Advanced Telecom Computing Architecture) bietet üblicherweise Platz für 14 bis 16 Steckbaugruppen nebeneinander. Die Gesamtverlustleistung liegt somit bei etwa 3.000 Watt. Diese Wärme muss effektiv abgeführt werden, um eine Überhitzung und einen Ausfall der Steckbaugruppen zu verhindern.

Um den in den Schaltschränken zur Verfügung stehenden Raum optimal auszunutzen, weisen die einzelnen Gehäuse nur einen relativ geringen Raumbedarf für die Luftführung der Kühlluft auf. Diese Reduzierung an Raum für eine Kühlluftführung steht der immer höheren Abwärme und den gestiegenen Anforderungen an die Kühlung diametral entgegen.

Im Stand der Technik sind Telekommunikationssysteme bekannt, bei denen mehrere kleine Lüfter unterhalb des Einbauraums der Steckbaugruppen angeordnet sind und Luft vertikal an den Steckbaugruppen entlang nach oben drücken. Die Kühlluft tritt dann oberhalb des Einbauraums seitlich aus dem Gehäuse, in der Regel an der Rückseite, wieder heraus. Da die Lüfter von der einströmenden kühlen Luft umströmt werden, ist ihre Temperaturbelastung gering, was sich positiv auf ihre Lebensdauer auswirkt. Die Luftführung oberhalb des Einbauraums ist jedoch wenig effektiv.

Bei anderen Gehäusen werden Axiallüfter oberhalb der Steckbaugruppe angeordnet. Um die Luftführung zu verbessern und einen Luftstau in dem Raum oberhalb des Einbauraums zu vermeiden ist bekannt, die einzelnen Lüfter schräg zu stellen, damit der Abluftstrom über die anderen Lüfter hinwegströmt. Dieses lässt sich aufgrund der vorgegebenen Bauhöhe der Gehäuse häufig jedoch nicht realisieren. Ein Beispiel hierfür ist die US 2003/0214785 A1. Ein anderes Beispiel für die Anordnung und Verwendung von Axiallüftern zur Kühlung von Gehäusen ist aus der US 6,042,474 bekannt.

Anstelle von Axiallüftern werden insbesondere bei Gehäusen für Telekommunikationsanwendungen häufig Radiallüfter eingesetzt, die konstruktionsbedingt bereits eine 90°-Umlenkung des Luftstroms umfassen. Die oberhalb des Einbauraums der Steckbaugruppen angeordneten Radiallüfter saugen die Luft von unten an und geben sie seitlich durch den Luftaustritt des Gehäuses ab. Eine Möglichkeit zur effektiven Kühlung derartiger ATCA-Standard-Gehäuse für Telekommunikationsanwendungen ist beispielsweise aus der EP 1 705 977 bekannt. Allerdings ist die Verwendung von Radiallüftern relativ teuer, so dass nach alternativen Lösungen gesucht wird.

Aufgabe der vorliegenden Erfindung ist es deshalb, ein Gehäuse zur Aufnahme von elektronischen Steckbaugruppen vorzuschlagen, das eine möglichst hohe Kühlleistung erzeugt und gegenüber den bekannten Gehäusen optimiert ist.

Gelöst wird die Aufgabe durch ein Gehäuse mit den Merkmalen des Anspruchs 1.

Das erfindungsgemäße Gehäuse zur Aufnahme von elektronischen Steckbaugruppen hat einen Einbauraum zur Aufnahme der Steckbaugruppen, der zur Vorderseite des Gehäuses hin offen ist. Oberhalb des Einbauraums ist ein Lüfterraum angeordnet, in dem sich wenigstens ein Axiallüfter befindet. Der Lüfterraum hat eine nach oben abschließende Deckplatte und einen seitlichen Luftaustritt. Bevorzugt ist der seitliche Luftaustritt an der Rückseite des Gehäuses angeordnet.

Der Axiallüfter verfügt über einen Luftauslass an einer Lüfteroberseite. Er ist derart im Lüfterraum angeordnet, dass Luft aus dem Einbauraum angesaugt wird. Die angesaugte Luft strömt aus dem seitlichen Luftaustritt des Lüfterraums aus dem Gehäuse heraus. Zwischen der Lüfteroberseite des Axiallüfters und der Deckplatte des Lüfterraums ist erfindungsgemäß ein Luftleitblech positioniert, das sich in Richtung Luftaustritt des Lüfterraums erstreckt.

Im Rahmen der Erfindung hat sich herausgestellt, dass aufgrund der Weiterentwicklung der Axiallüfter nun Lüfter eingesetzt werden können, die eine derart hohe Luftleistung erzeugen, dass die Nachteile durch die fehlende Luftführung mit 90° Umlenkung keine oder nur sehr geringe Auswirkungen auf die Entlüftung der Gehäuse haben. Trotz einzelner sich bereichsweise bildender Luftverwirbelungen im Lüfterraum oberhalb des Einbauraums der Steckbaugruppen ist die Entlüftungsleistung hinreichend. Dies liegt insbesondere an den sehr hohen Drehzahlen der neuen Lüfter.

Allerdings ergibt sich das Problem, dass aufgrund der hohen Luftströmung durch die Axiallüfter mit den hohen Drehzahlen die Luft an die Deckplatte des Luftführungsraums prallt und von dieser wieder entgegen der Luftströmung in Richtung Axiallüfter gedrückt wird. Dabei wird von den Schaufeln des Axiallüfters Luft teilweise wieder in den Einbauraum des Gehäuses bewegt, wodurch der Einbauraum mit erwärmter Luft durchströmt und der Gesamtluftstrom aufgrund der entgegen gerichteten "Leckströmung" reduziert wird.

Im Rahmen der Erfindung wurde herausgefunden, dass die entgegen den Kühlluftstrom gerichtete Leckströmung jedoch nur auftritt, wenn eine Luftsäule oberhalb des Auslasses des Axiallüfters gebildet wird. Untersuchungen im Rahmen der Erfindung haben ergeben, dass durch die Anordnung eines Luftleitbleches oberhalb des Auslasses des Axiallüfters das Entstehen einer derartigen Luftsäule effektiv und effizient verhindert werden kann. Das Luftleitblech trennt den aus dem Luftauslass des Axiallüfters austretenden Luftstrom in zwei Teilströme, so dass das Problem der rückgerichteten Leckströmung nicht auftritt.

Erfindungsgemäß hat sich bei den Untersuchungen gezeigt, dass ein Luftleitblech, das sich in Richtung des Luftaustritts des Lüfterraums erstreckt, die Luftleistung optimiert und das Entstehen des rückgerichteten Leckstroms bestmöglich verhindert.

In einer bevorzugten Ausführungsform des erfindungsgemäßen Gehäuses ist das als Trennblech ausgebildete Luftleitblech vertikal im Lüfterraum angeordnet. Das in der Regel flache Luftleitblech hat eine Luftleitblechflachseite, die derart angeordnet ist, dass ihre Flächennormale senkrecht zu der Lüfterachse, also zur Rotationsachse des Lüfterrads des Axiallüfters, ausgerichtet ist.

Der Begriff Lüfterraum, der oberhalb des Einbauraums angeordnet ist, ist so zu verstehen, dass dies ein Raum ist, in dem sich der Axiallüfter befindet. Dieser Raum kann durchaus auch von einer Einschubkassette gebildet sein, die in einen Bereich des Gehäuses eingeschoben wird. Ebenfalls ist es möglich, dass oberhalb des Einbauraums mehrere (nebeneinander angeordnete) Lüfterräume vorgesehen sind. Eine derartige Ausführungsform umfasst beispielsweise zwei oder drei nebeneinander angeordnete Lüfterkassetten. Die Lüfterkassetten ihrerseits können einen oder mehrere Lüfter aufweisen.

In einer bevorzugten Ausführungsform sind in dem Lüfterraum zwei Axiallüfter enthalten, beispielsweise in einer Lüfterkassette. Die beiden Axiallüfter sind bevorzugt derart nebeneinander angeordnet, dass der eine Axiallüfter nahe dem Luftaustritt des Lüfterraums bzw. der Lüfterkassette und der andere Axiallüfter nahe der Seitenwand angeordnet ist, die dem Luftaustritt des Lüfterraums gegenüber liegt.

Weiter bevorzugt wird bei dieser Ausführungsform mit zwei Axiallüftern jedem Axiallüfter ein getrennter Luftführungsraum zugeordnet. Der Lüfterraum weist damit zwei Luftführungsräume auf. Vorzugsweise sind die beiden Lüfterräume derart ausgebildet und angeordnet, dass sie wenigstens in Teilbereichen übereinander liegen. Bevorzugt ist der Luftführungsraums des dem Luftaustritt des Lüfterraums benachbarten Axiallüfters wenigstens teilweise unterhalb des Luftführungsraums des dem Luftaustritt entfernt angeordneten Axiallüfters angeordnet.

Ist der Luftaustritt des Lüfterraums an der hinteren Gehäusewand vorgesehen, so ist der hintere Lüfter in seiner vertikalen Position unterhalb des vorderen Lüfters angeordnet, wobei sich die beiden Lüfter bevorzugt nicht überlappen.

In einer bevorzugten Ausführungsform ist das Luftleitblech in dem Luftführungsraum positioniert, in dem der dem Luftaustritt benachbarte Axiallüfter angeordnet ist. Mit anderen Worten umfasst der dem Luftaustritt benachbarte Luftführungsraum das erfindungsgemäße Luftleitblech. Selbstverständlich können auch beide oder mehrere Luftführungsräume mit einem Luftleitblech ausgebildet sein.

Die Erfindung wird nachfolgend anhand von in den Figuren dargestellten bevorzugten Ausführungsformen näher erläutert. Die darin dargestellten Besonderheiten können einzeln oder in Kombination verwendet werden, um bevorzugte Ausgestaltungen der Erfindung zu schaffen. Die beschriebenen Ausführungsformen stellen keine Einschränkung der Allgemeinheit des in den Ansprüchen definierten Gegenstands dar. Es zeigen:
- Figur 1: ein Prinzipschaltbild eines erfindungsgemäßen Gehäuses mit einem Axiallüfter;
- Figuren 2, 3: zwei Seitenansichten des Gehäuses aus Fig. 1;
- Figur 4: eine alternative Ausführungsform eines erfindungsgemäßen Gehäuses;
- Figuren 5, 6: ein Diagramm zur Wirkungsweise eines Luftleitblechs in einem Lüfterraum eines Gehäuses.

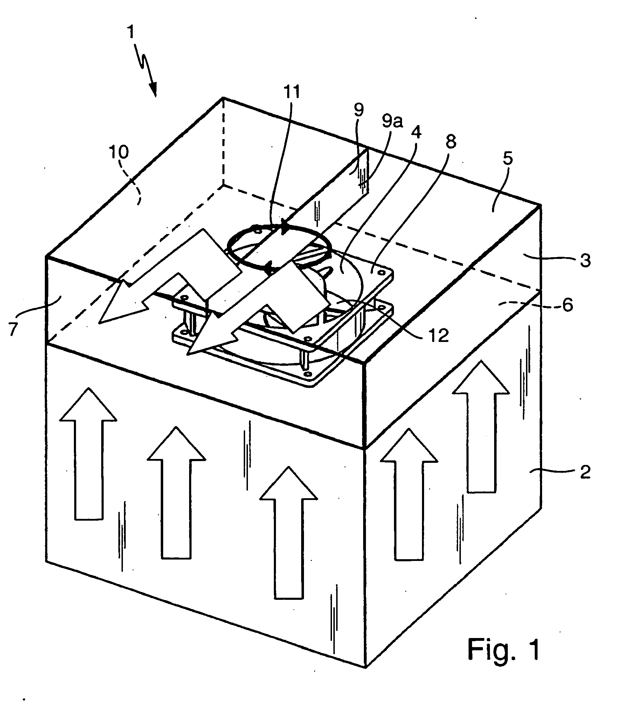

Fig. 1 zeigt ein perspektivisches Prinzipschaltbild eines erfindungsgemäßen Gehäuses 1 mit einem Einbauraum 2 für hier nicht dargestellte Steckbaugruppen, die vertikal in dem Einbauraum 2 angeordnet sind. In der Regel sind die Steckbaugruppen in Führungsschienen innerhalb des Einbauraums 2 gelagert. Oberhalb des Einbauraums 2 ist ein Lüfterraum 3 angeordnet, der einen Axiallüfter 4 umfasst. Der Lüfterraum 3 wird nach oben hin durch eine Deckplatte 5 und nach unten durch eine Zwischenplatte 6 begrenzt. Die optimale Zwischenplatte 6 trennt den Einbauraum 2 von dem Lüfterraum 3.

Fig. 1 zeigt das Gehäuse von der Gehäuserückseite, an der der Luftaustritt 7 des Lüfterraums 3 zu sehen ist. Der Luftaustritt 7 ist an einer der Gehäuseseiten 10 angeordnet, vorzugsweise an der Rückseite.

Der Axiallüfter 4 saugt Luft aus dem Einbauraum 2 an, die den Einbauraum 2 bevorzugt im Wesentlichen in vertikaler Richtung durchströmt. Diese Kühlluft dringt in der Regel durch einen Luftzuführraum in den Einbauraum 2, der unterhalb des Einbauraums 2 angeordnet ist. In vielen Ausführungsformen weist der Luftzuführraum eine Lufteintrittsöffnung an der Frontseite des Gehäuses auf.

Erfindungsgemäß ist zwischen der Deckplatte 5 und einer Oberseite 8 des Axiallüfters 4 ein Luftleitblech 9 angeordnet. Das Luftleitblech 9 ist bevorzugt vertikal im Lüfterraum angeordnet, wie in den Figuren 1 bis 3 dargestellt.

In einer bevorzugten Ausführungsform erstreckt sich das Luftleitblech 9 im Lüfterraum 3 von einer dem Luftaustritt 7 gegenüberliegenden Seitenwand 10 in Richtung des Luftaustritts 7 des Lüfterraums 3.

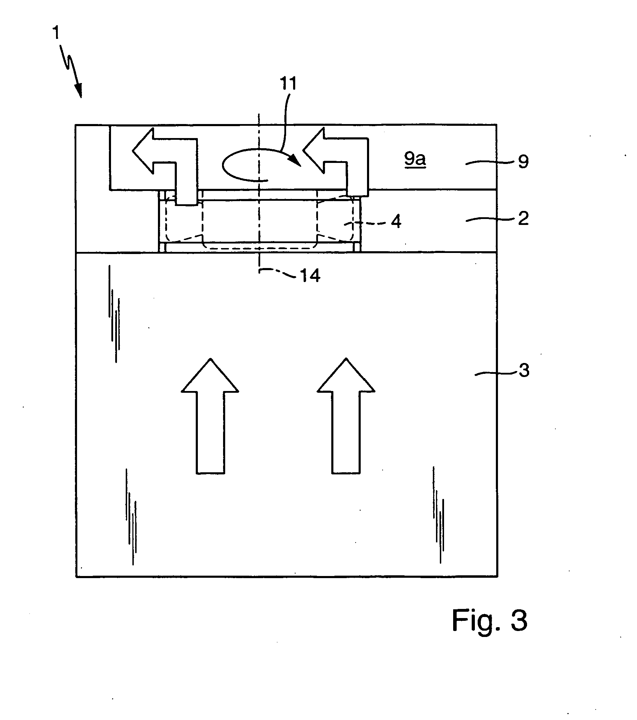

In den Figuren 1 und 3 ist zu erkennen, dass ein Ende des Luftleitblechs 9 von dem Luftaustritt 7 an der Gehäusewand beabstandet ist. Das Luftleitblech 9 nimmt also nicht den gesamten Raum (Dimension des Raums in Richtung Luftleitblech 9) in Anspruch.

Das Luftleitblech 9 ist zwischen der Deckplatte 5 und der Lüfteroberseite 8 derart ausgerichtet, dass die Flächennormale der Luftleitblechflachseite 9a senkrecht zur Lüfterachse 14 orientiert ist. Als Lüfterachse 14 wird die Drehachse des Axiallüfters 4 bezeichnet, um die sich das Lüfterrad dreht. Aufgrund der hohen Umdrehungszahl des Axiallüfters 4 würde sich ohne den Einsatz des Luftleitblechs 9 eine Luftsäule oberhalb des Axiallüfters 4 ausbilden. Die Luftsäule hätte die gleiche Drehrichtung wie der Axiallüfter 4 und ist durch einen Pfeil 11 angedeutet. Durch die Anordnung des Luftleitblechs 9 an der Oberseite 8 des Axiallüfters 4 kann sich diese Luftsäule nicht ausbilden. Die Luftverwirbelungen werden dadurch stark reduziert.

Bevorzugt ist das Luftleitblech 9 im Lüfterraum 3 derart angeordnet, dass es sich oberhalb des Luftauslasses 12 des Axiallüfters 4 erstreckt und einen definierten Abstand 13 zu der Lüfterachse 14 aufweist. Im Rahmen der Erfindung wird der Abstand 13 so definiert, dass er die Flächennormale der Luftleitblechflachseite 9a ausgerichtete Strecke ist, die senkrecht zu einer parallel zu dem Luftleitblech 9 gebildeten Ebene steht. Somit ist das Luftleitblech 9 bevorzugt zu einer Seitenwand 10 des Gehäuses 1 parallel angeordnet.

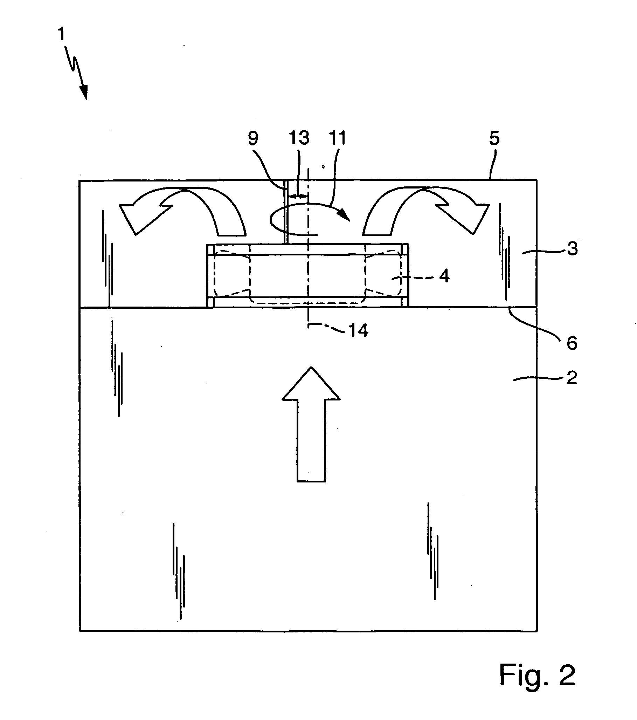

Ebenfalls bevorzugt ist eine Anordnung des Luftleitblechs, in der der Abstand 13 von der Lüfterachse 14 des Axiallüfters 4 definiert ist. In einer bevorzugten Ausführungsform ist der Abstand 13 höchstens so groß wie 70% des Radius des Luftauslasses 12. Besonders bevorzugt ist der Abstand höchstens 50% des Radius des Luftauslasses 12. Untersuchungen im Rahmen der Erfindung haben ergeben, dass bei einem Abstand 13 von höchstens 30% des Radius des Luftauslasses 12 sehr gute Ergebnisse in der Luftführung und der Effizienz der Wärmeabführung erzielt wurden. Auch eine Begrenzung des Abstands 13 auf höchstens 10% des Radius des Luftauslasses 12 hat noch gute Verbesserungen gezeigt. In Fig. 2 ist zu erkennen, dass der hier gewählte Abstand 13 ca. 20% des Radius des Luftauslasses 12 beträgt.

Weitere Untersuchungen haben ergeben, dass die Position des Luftleitblechs 9 innerhalb des Lüfterraums 3 auch abhängig von der Entfernung zur Seitenwand 10 des Lüfterraums 3 ist.

Wie in den Figuren 1 bis 3 gezeigt, ist die Größe des Luftleitblechs 9 in vertikaler Richtung bevorzugt so dimensioniert, dass das Luftleitblech 9 mit der Deckplatte 5 und der Lüfteroberseite 8 jeweils bündig abschließt. Der gesamte zur Verfügung stehende Raum (Abstand zwischen Deckplatte 5 und Oberseite 8) wird durch das Luftleitblech 9 ausgefüllt.

Alternativ ist es möglich, dass sich das Luftleitblech 9 nicht über den gesamten Abstand zwischen Oberseite 8 und Deckplatte 5 erstreckt, sondern dass zwischen der Oberkante des Luftleitblechs 9 und der Deckplatte 5 ein Spalt gebildet wird. Das Spaltmaß beträgt bevorzugt höchstens die Hälfte des Abstands zwischen Lüfteroberseite 8 und Deckplatte 5.

In einer bevorzugten Ausführungsform ist die Vertikaldimension des Luftleitblechs 9 im Vergleich zu dem Abstand zwischen der Deckplatte 5 des Lüfterraums 3 und der Lüfteroberseite 8 mindestens 40%, bevorzugt mindestens 70% und besonders bevorzugt mindestens 95%. Je größer das Luftleitblech 9 in seiner Vertikaldimension in Bezug auf die freie Höhe oberhalb der Lüfteroberseite 8 ist, desto zuverlässiger werden die entstehenden Luftsäulen verhindert und eine rückfließende Leckströmung ausgeschlossen.

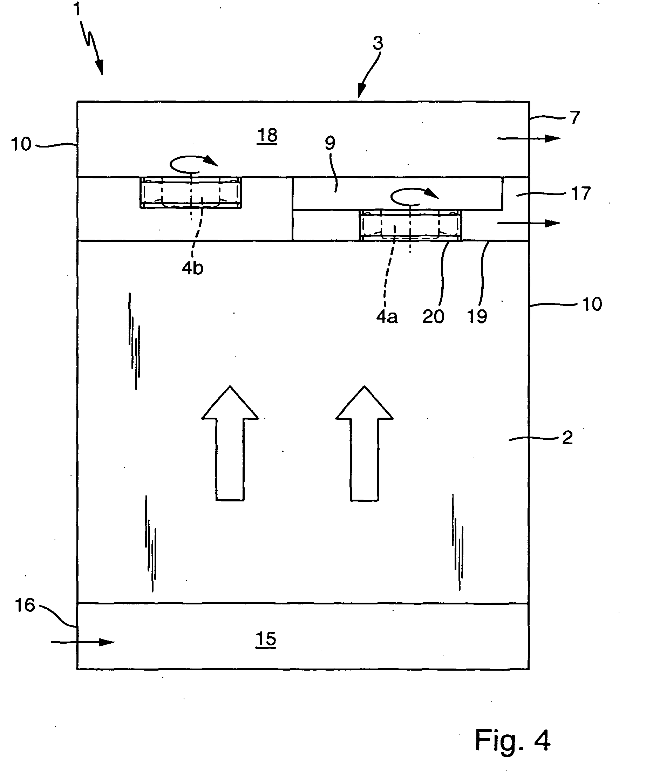

Fig. 4 zeigt eine alternative Ausführungsform eines erfindungsgemäßen Gehäuses 1, in dem zwei Axiallüfter 4a, 4b angeordnet sind. Unterhalb des Einbauraums 2 ist ein Luftaufnahmeraum 15 angeordnet, durch dessen Lufteintritt 16 Kühlluft in das Gehäuse 1 einströmen kann. Die Kühlluft wird von den beiden Axiallüftern 4a, 4b angesaugt, so dass sie den Einbauraum 2 vertikal zwischen den (hier nicht dargestellten) Steckbaugruppen durchströmt und diese kühlt. In dem Lüfterraum 3 werden zwei Luftführungsräume 17, 18 gebildet, die an der hinteren Seitenwand 10 (rechte Seitenwand in Fig. 4) des Gehäuses 1 enden. Die durch den Einbauraum 2 strömende Kühlluft wird durch die Luftführungsräume 17, 18 geführt und tritt aus dem Luftaustritt 7 aus dem Gehäuse 1 heraus. Die beiden Axiallüfter 4a, 4b sind in unterschiedlichen Vertikalpositionen innerhalb des Gehäuses 1 angeordnet, so dass sich der Luftführungsraum 18, der vom Luftführungsraum 17 getrennt ist, teilweise oberhalb des Luftführungsraums 17 erstreckt.

Aus Fig. 4 ist zu entnehmen, dass die Höhe (vertikale Richtung) des Luftführungsraums 18 größer ist als die des Luftführungsraums 17. Der Effekt der Leckströmung tritt deshalb hauptsächlich in dem Luftführungsraum 17 auf, da die auf die Deckplatte 5 des Luftführungsraums 17 treffende Luft wieder entgegen der Strömungsrichtung gedrückt wird. Das Luftleitblech 9 ist deshalb nur im niedrigeren Luftführungsraum 17 montiert. Es ist in der oben beschriebenen Art und Weise angeordnet, wobei es sich nicht über die gesamte Breite des Luftführungsraums 17 erstreckt.

In einer alternativen Ausführungsform kann das Gehäuse 1 einen Zwischenboden 19 zwischen dem Lüfterraum 3 und dem Einbauraum 2 aufweisen. Der Zwischenboden 19 hat eine Öffnung 20, oberhalb der der Axiallüfter 4a so angeordnet ist, dass die Unterseite des Lüfters 4a den Zwischenboden 19 kontaktiert.

In Fig. 4 ist der Zwischenboden 19 zwischen dem Luftführungsraum 17 und dem Einbauraum 2 angeordnet. Der Axiallüfter 4a ist oberhalb der Öffnung 20 positioniert, wobei die Öffnung 20 mit einem Lufteinlass des Axiallüfters 4a korrespondiert. Dadurch kann der Axiallüfter 4a auf dem Zwischenboden 19 montiert werden.

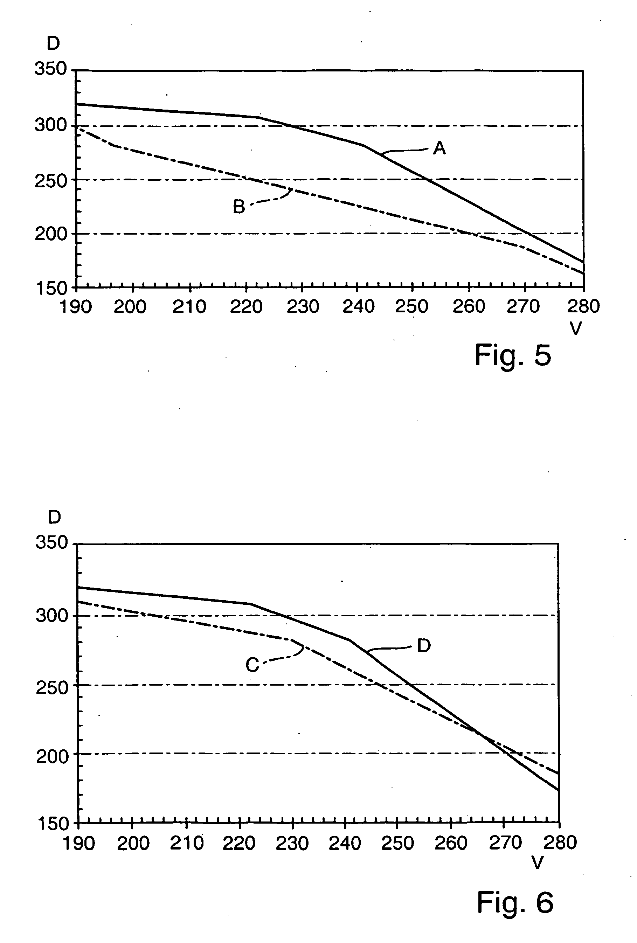

In den Figuren 5 und 6 werden Untersuchungsergebnisse gezeigt, die durch den Einsatz des Luftleitblechs 9 Verbesserungen erzielten. In beiden Figuren wird die erzielte Druckdifferenz D über dem Luftvolumenstrom V dargestellt. Die hierbei verwendeten Axiallüfter 4 weisen einen Arbeitsbereich auf, in dem ein Luftvolumenstrom V von ca. 200 bis 270 m³/h (Kubikmeter pro Stunde) erzielt wird. Je höher die erreichte Druckdifferenz, desto besser sind die Effektivität und die Entlüftung des Gehäuses.

In Fig. 5 zeigt die Kurve B die Effektivität des eingesetzten Axiallüfters 4 ohne Verwendung eines Luftleitblechs 9. Die Kurve A stellt die Druckdifferenz D bei Verwendung eines Luftleitblechs 9 dar, wie sie anhand der vorhergehenden Figuren beschrieben ist. Deutlich zu erkennen ist, dass gerade im Arbeitsbereich des Lüfters 4 die Effektivität und damit die Entwärmung des Gehäuses 1 deutlich steigt.

Fig. 6 zeigt die erzielte Druckdifferenz innerhalb des Gehäuses 1 bei zwei verschiedenen Anordnungen des Luftleitblechs. Die Kurve C zeigt die Anordnung des Luftleitblechs 9 oberhalb der Lüfterachse 14. Die Kurve D zeigt die Druckdifferenz bei einer Anordnung des Luftleitblechs 9 ca. 10 mm von der Lüfterachse 14 entfernt, wobei der Abstand 13 zur Lüfterachse 14 so definiert wird, dass das Luftleitblech 9 parallel zu einer der Seitenwände 10 des Gehäuses 1 ausgerichtet ist. Der hier verwendete Abstand 13 von 10 mm entspricht etwa 10% des Radius des eingesetzten Axiallüfters 4. Auch hier ist zu erkennen, dass die Effektivität des eingesetzten Lüfters 4 durch eine optimierte Anordnung des Luftleitblechs 9 innerhalb des Lüfterraums 3 verbessert werden kann. Insbesondere im Arbeitsbereich des Lüfters 4 wird eine Steigerung um etwa 5% erzielt.

## Patentansprüche

1. Gehäuse zur Aufnahme von elektronischen Steckbaugruppen mit
- einem zur Vorderseite des Gehäuses (1) hin offenen Einbauraum (2) für die Steckbaugruppen und
- einem oberhalb des Einbauraums (2) angeordneten Lüfterraum (3) mit einer Deckplatte (5) und einem seitlichen Luftaustritt (7) und wenigstens einem Axiallüfter (4) mit einem Luftauslass (12) an einer Lüfteroberseite (8),
wobei
- der Axiallüfter (4) in dem Lüfterraum (3) derart angeordnet ist, dass Luft aus dem Einbauraum (2) angesaugt wird; und **dadurch gekennzeichnet, dass**
- zwischen der Lüfteroberseite (8) des Axiallüfters (4) und der Deckplatte (5) des Lüfterraums (3) ein Luftleitblech (9) positioniert ist, das sich in Richtung Luftaustritt (7) des Lüfterraums (3) erstreckt.

2. Gehäuse nach Anspruch 1, **dadurch gekennzeichnet, dass** sich das Luftleitblech (9) von einer dem Luftaustritt (7) gegenüberliegenden Seitenwand (10) des Lüfterraums (3) in Richtung des Luftaustritts (7) des Lüfterraums (3) erstreckt.

3. Gehäuse nach Anspruch 1 oder 2, **dadurch gekennzeichnet, dass** das Luftleitblech (9) vertikal im Lüfterraum (3) angeordnet ist.

4. Gehäuse nach einem der vorhergehenden Ansprüche, **dadurch gekennzeichnet, dass** das Luftleitblech (9) im Lüfterraum (3) derart angeordnet ist, dass es sich oberhalb des Luftauslasses (12) des Axiallüfters (4) erstreckt und einen definierten Abstand (13) zu der Lüfterachse (14) aufweist.

5. Gehäuse nach Anspruch 4, **dadurch gekennzeichnet, dass** der Abstand (13) zwischen dem Luftleitblech (9) und der Lüfterachse (14) des Axiallüfters (4) höchstens 70% des Radius des Luftauslasses (12) des Axiallüfters (4), bevorzugt höchstens 50% des Radius, sehr bevorzugt höchstens 30% des Radius und besonders bevorzugt höchstens 5% des Radius beträgt.

6. Gehäuse nach einem der vorhergehenden Ansprüche, **dadurch gekennzeichnet, dass** das Gehäuse (1) einen Zwischenboden (19) zwischen dem Lüfterraum (3) und dem Einbauraum (2) aufweist, der eine Öffnung (20) hat, und dass der Lüfter (4) derart oberhalb der Öffnung (20) des Zwischenbodens (19) angeordnet ist, dass die Unterseite des Lüfters (4) den Zwischenboden (19) kontaktiert.

7. Gehäuse nach einem der vorhergehenden Ansprüche, **dadurch gekennzeichnet, dass** die Vertikaldimension des Luftleitblechs (9) im Vergleich zu dem Abstand zwischen der Deckplatte (5) des Lüfterraums (3) und der Lüfteroberseite (8) mindestens 40%, bevorzugt mindestens 70% und besonders bevorzugt mindestens 95% ist.

8. Gehäuse nach einem der vorhergehenden Ansprüche, **dadurch gekennzeichnet, dass** der Lüfterraum (2) zwei Axiallüfter (4a, 4b) umfasst, die derart nebeneinander angeordnet sind, dass der eine Axiallüfter (4a) nahe dem Luftaustritt (7) des Lüfterraums (3) und der andere Axiallüfter (4b) nahe der dem Luftaustritt (7) des Lüfterraums (3) gegenüberliegenden Seitenwand (10) angeordnet ist.

9. Gehäuse nach Anspruch 8, **dadurch gekennzeichnet, dass** jeder Axiallüfter (4a, 4b) einen getrennten Luftführungsraum (17, 18) hat.

10. Gehäuse nach Anspruch 9, **dadurch gekennzeichnet, dass** die Luftführungsräume (17, 18) wenigstens teilweise übereinander angeordnet sind.

11. Gehäuse nach Anspruch 10, **dadurch gekennzeichnet, dass** das Luftleitblech (9) in dem Luftführungsraum (17) des dem Luftaustritt (7) benachbarten Axiallüfters (4a) angeordnet ist.

## Claims

1. A housing for accommodating electronic plug-in assemblies including
- an installation space (2) open towards the front side of the housing (1) for the plug-in assemblies and
- a fan space (3) arranged above the installation space (2) with a cover plate (5) and a lateral air outlet (7) and at least one axial fan (4) with an air outlet (12) at the upper surface (8) of the fan, wherein
- the axial fan (4) is so arranged in the fan space (3) that air is drawn out of the installation space (2); and **characterised in that**
- positioned between the upper surface (8) of the axial fan (4) and the cover plate (5) of the fan space (3) there is an air-guiding plate (9), which extends in the direction of the air outlet (7) of the fan space (3).

2. A housing as claimed in claim 1, **characterised in that** the air-guiding plate (9) extends from a side wall (10) of the fan space (3) opposite to the air outlet (7) in the direction of the air outlet (7) of the fan space (3).

3. A housing as claimed in claim 1 or 2, **characterised in that** the air-guiding plate (9) is arranged vertically in the fan space (3).

4. A housing as claimed in one of the preceding claims, **characterised in that** the air-guiding plate (9) is so arranged in the fan space (3) that it extends above the air outlet (12) of the axial fan (4) and has a defined spacing (13) from the fan axis (14).

5. A housing as claimed in claim 4, **characterised in that** the spacing (13) between the air-guiding plate (9) and the fan axis (14) of the axial fan (4) is at most 70% of the radius of the air outlet (12) of the axial fan (4), preferably at most 50% of the radius, very preferably at most 30% of the radius and particularly preferably at most 5% of the radius.

6. A housing as claimed in one of the preceding claims, **characterised in that** the housing (1) has an intermediate base (19) between the fan space (3) and the installation space (2), which has an opening (20) and that the fan (4) is so arranged above the opening (20) in the intermediate base (19) that the underside of the fan (4) contacts the intermediate base (19).

7. A housing as claimed in one of the preceding claims, **characterised in that** the vertical dimension of the air-guiding plate (9) is at least 40%, preferably at least 70% and particularly preferably at least 95% in comparison to the spacing between the cover plate (5) of the fan space (3) and the upper surface (8) of the fan.

8. A housing as claimed in one of the preceding claims, **characterised in that** the fan space (2) contains two axial fans (4a), (4b) which are arranged adjacent to one another such that the one axial fan (4a) is arranged close to the air outlet (7) of the fan space (3) and the other axial fan (4b) is arranged close to the side wall (10) opposite to the air outlet (7) of the fan space (3).

9. A housing as claimed in claim 8, **characterised in that** each axial fan (4a), (4b) has a separate air-guiding space (17), (18).

10. A housing as claimed in claim 9, **characterised in that** the air-guiding spaces (17), (18) are arranged at least partially above one another.

11. A housing as claimed in claim 10, **characterised in that** the air-guiding plate (9) is arranged in the air-guiding space (17) of the axial fan (4a) adjacent to the air outlet (7).

## Revendications

1. Boîtier pour la réception de modules électroniques enfichables comprenant
- un espace de montage (2) pour les modules enfichables ouvert en direction de la face avant du boîtier (1), et
- un espace de ventilation (3), disposé au-dessus de l'espace de montage (2) comprenant une plaque de couverture (5) et une sortie d'air latérale (7) et au moins un ventilateur axial (4) avec un échappement d'air (12) sur une face supérieure (8) du ventilateur,
dans lequel
- le ventilateur axial (4) est disposé dans l'espace de ventilation (3) de telle sorte que de l'air soit aspiré de l'espace de montage (2) ; **caractérisé en ce que**
- un déflecteur d'air (9) est positionné entre la face supérieure (8) du ventilateur axial (4) et la plaque de couverture (5) de l'espace de ventilation (3), lequel déflecteur s'étend en direction de la sortie d'air (7) de l'espace de ventilation (3).

2. Boîtier suivant la revendication 1, **caractérisé en ce que** le déflecteur d'air (9) s'étend d'une paroi latérale (10) de l'espace de ventilation (3) située en vis-à-vis de la sortie d'air (7) en direction de la sortie d'air (7) de l'espace de ventilation (3).

3. Boîtier suivant l'une des revendications 1 et 2, **caractérisé en ce que** le déflecteur d'air (9) est disposé verticalement dans l'espace de ventilation (3).

4. Boîtier suivant l'une des revendications précédentes, **caractérisé en ce que** le déflecteur d'air (9) est disposé dans l'espace de ventilation (3) de telle sorte qu'il s'étend au-dessus de l'échappement d'air (12) du ventilateur axial (4) et présente une distance définie (13) par rapport à l'axe (14) du ventilateur.

5. Boîtier suivant la revendication 4, **caractérisé en ce que** la distance (13) maximale entre le déflecteur d'air (9) et l'axe (14) du ventilateur axial (4) est égale à 70% du rayon de l'échappement d'air (12) du ventilateur axial (4), de préférence à 50% du rayon, très préférentiellement à 30% du rayon et de façon particulièrement préférentielle à 5% du rayon.

6. Boîtier suivant l'une des revendications précédentes, **caractérisé en ce que** le boîtier (1) présente un fond intermédiaire (19) pourvu d'une ouverture (20) entre l'espace de ventilation (3) et l'espace de montage (2), et que le ventilateur (4) est disposé au-dessus de l'ouverture (20) du fond intermédiaire (19) de telle sorte que la face inférieure du ventilateur (4) soit au contact du fond intermédiaire (19).

7. Boîtier suivant l'une des revendications précédentes, **caractérisé en ce que** la dimension verticale du déflecteur d'air (9) par rapport à la distance entre la plaque de couverture (5) de l'espace de ventilation (3) et la face supérieure (8) du ventilateur est d'au moins 40%, de préférence d'au moins 70% et de façon particulièrement préférentielle d'au moins 95%.

8. Boîtier suivant l'une des revendications précédentes, **caractérisé en ce que** l'espace de ventilation (2) comporte deux ventilateurs axiaux (4a, 4b) qui sont juxtaposés de telle sorte que l'un des ventilateurs axiaux (4a) soit disposé au voisinage de la sortie d'air (7) de l'espace de ventilation (3) et l'autre ventilateur axial (4b) soit disposé au voisinage de la paroi latérale (10) située en vis-à-vis de la sortie d'air (7) de l'espace de ventilation (3).

9. Boîtier suivant la revendication 8, **caractérisé en ce que** chaque ventilateur axial (4a, 4b) a un espace de guidage d'air séparé (17, 18).

10. Boîtier suivant la revendication 9, **caractérisé en ce que** les espaces de guidage d'air (17, 18) sont au moins en partie superposés.

11. Boîtier suivant la revendication 10, **caractérisé en ce que** le déflecteur d'air (9) est disposé dans l'espace de guidage d'air (17) du ventilateur axial (4a) voisin de la sortie d'air (7).
